(19) Europäisches Patentamt
European Patent Office
Office européen des brevets

(11) **EP 1 424 383 B1**

(12) **EUROPEAN PATENT SPECIFICATION**

(45) Date of publication and mention
of the grant of the patent:
**09.05.2007 Bulletin 2007/19**

(51) Int Cl.:
***C09K 19/38*** *(2006.01)*     ***C08G 59/24*** *(2006.01)*
***C09K 19/54*** *(2006.01)*

(21) Application number: **03256089.8**

(22) Date of filing: **27.09.2003**

(54) **Thermally-conductive epoxy resin molded article and method of manufacturing the same**

Thermisch leitfähiger aus Epoxidharz gegossener Artikel und Herstellunsverfahren desselben

Article moule de colle epoxy thermoconductrice et procede de le preparer

(84) Designated Contracting States:
**DE FR GB NL**

(30) Priority: **27.11.2002 JP 2002343822**

(43) Date of publication of application:
**02.06.2004 Bulletin 2004/23**

(73) Proprietor: **POLYMATECH CO., LTD.**
**Tokyo 103-8428 (JP)**

(72) Inventors:
  • **Tobita, Masayuki**
   **Isesaki-shi**
   **Gunma 372-0812 (JP)**
  • **Shimoyama, Naoyuki**
   **Saitama-shi**
   **Saitama 336-0964 (JP)**
  • **Ishigaki, Tsukasa**
   **Saitama-shi**
   **Saitama 336-0964 (JP)**

  • **Aoki, Hisashi**
   **Tama-shi**
   **Tokyo 206-0033 (JP)**
  • **Kimura, Toru**
   **Funabashi-shi**
   **Chiba 273-0047 (JP)**
  • **Ochi, Mitsukazu**
   **Ibaraki-shi**
   **Osaka 567-0046 (JP)**

(74) Representative: **O'Brien, Niall James et al**
 **Urquhart-Dykes & Lord LLP**
 **30 Welbeck Street**
 **London W1G 8ER (GB)**

(56) References cited:
 **US-A- 4 962 160**     **US-A- 5 266 660**
 **US-A- 5 391 651**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

BACKGROUND OF THE INVENTION

The present invention relates to a thermally-conductive epoxy resin molded article for conducting heat generated by electronic components or the like and a method of manufacturing the same, and more particularly to a thermally-conductive epoxy resin molded article having a high thermal conductivity and a method of manufacturing the same.

In recent years, the integration degree and speed in LSIs have increased, in accordance with a trend toward high performance, downsizing, and reduction in weight of electronic equipments, and the mounting density in semiconductor packages. Accordingly, the heat generated by various electronic parts has increased, and measures for dissipating heat out of the electronic parts become a very important task. For achieving this task, a thermally conductive molded article comprised of a heat-radiating material, such as a metal, ceramic, or a polymer composition, is used in heat-radiating members, such as print wiring boards, semiconductor packages, housings, pipes, heat radiating panels, and heat diffusion panels.

Among the above molded articles, thermally-conductive epoxy resin molded articles formed from epoxy resin compositions are excellent in electrical insulation properties, mechanical properties, heat resistance, chemical resistance, adhesive properties, and so forth, and therefore they are widely used as cast articles, laminated plates, sealing materials, and adhesives, mainly in electric and electronic fields.

Known as epoxy resin compositions constituting such thermally-conductive epoxy resin molded articles are those formed by mixing a thermally-conductive filler having a high thermal conductivity in a polymer matrix material, such as a resin and rubber. As the thermally-conductive fillers, there are conventionally used metal oxides, such as aluminum oxide, magnesium oxide, zinc oxide, and quartz, metal nitrides, such as boron nitride and aluminum nitride, metal carbides, such as silicon carbide, metal hydroxides, such as aluminum hydroxide, metals, such as gold, silver, and copper, carbon fibers, graphite, and the like.

On the other hand, when even higher thermal conductivity is required, there are used thermally-conductive epoxy resin compositions formed by mixing special thermally-conductive fillers in epoxy resin compositions and thermally-conductive epoxy resin molded articles. Known as thermally-conductive fillers of this kind are surface-modified aluminum oxide, spherical cristobalite, inorganic fillers having specific particle sizes, etc. The fillers are described in the following literatures:

    Japanese Patent Publication No. 06-51778
    Japanese Laid-Open Patent Publication No. 2001-172472
    Japanese Laid-Open Patent Publication No. 2001-348488
    However, recent electronic components generate larger amounts of heat due to improvement in their performance. Therefore, there is a demand of materials more excellent in thermal conductivity than the thermally-conductive epoxy resin molded articles obtained from the above compositions by the conventional technology.

BRIEF SUMMARY OF THE INVENTION

The invention has been made as a solution to the above problems, and an object thereof is to provide a thermally-conductive epoxy resin molded article having an excellent thermal conductivity, and a manufacturing method thereof.

Other aspects and advantages of the invention will become apparent from the following description, taken in conjunction with the accompanying drawings, illustrating by way of example the principles of the invention.

BRIEF DESCRIPTION OF THE DRAWINGS

The invention, together with objects and advantages thereof, may best be understood by reference to the following description of the presently preferred embodiments together with the accompanying drawings in which:

    Fig. 1 is a graph showing an equatorial diffraction pattern of a thermally-conductive epoxy resin molded article (Example 2) according to one embodiment of the invention;
    Fig. 2 is a graph showing an intensity distribution of the thermally-conductive epoxy resin molded article (Example 2) according to the embodiment, in an azimuth angle direction;
    Fig. 3 is a graph showing an equatorial intensity distribution of a conventional epoxy resin molded article of Comparative Example 1;
    Fig. 4 is a graph showing an intensity distribution of the conventional epoxy resin molded article of Comparative Example 1, in the azimuth angle direction;

Fig. 5 is a perspective view of a thermally-conductive sheet according to one embodiment of the present invention;

Fig. 6 is diagram showing a conceptual representation of a method of manufacturing a thermally-conductive sheet having a high degree of orientation in a direction of thickness thereof; and

Fig. 7 is a diagram showing a conceptual representation of a method of manufacturing a thermally-conductive sheet having a high degree of orientation in a direction parallel to the surface thereof.

DETAILED DESCRIPTION OF THE PREFERRED EMBODIMENTS

According to a first aspect of the present invention there is provided a thermally-conductive epoxy resin moulded article obtained by curing an epoxy resin composition containing an epoxy resin, characterised in that the degree of orientation $\alpha$ of the epoxy resin is equal to or larger than 0.5 and smaller than 1.0,

the thermally-conductive epoxy resin moulded article is a sheet,

the epoxy resin is a liquid crystalline epoxy resin having at least one mesogenic group in respective molecules thereof,

the mesogenic group of the epoxy resin is oriented in a direction of thickness of the sheet or in a direction parallel to a surface of the sheet, and a coefficient of thermal conductivity $\lambda$ in the direction of thickness or direction parallel to the surface thereof is 0.5 to 30 W/(m·K).

The degree of orientation $\alpha$ is calculated using the following equation (1) from measurements of wide angle x-ray diffraction, which is a kind of x-ray diffraction measurement based on a transmission method:

$$\text{the degree of orientation } \alpha = (180 - \Delta\beta)/180 \ ... \ (1)$$

wherein $\Delta\beta$ represent a half-width in an intensity distribution measured by fixing to a peak scattering angle in the x-ray diffraction measurement, and then changing an azimuth angle from 0 degree to 360.

The thermally-conductive epoxy resin molded article can be applied to heat-dissipating members, such as a printed circuit board, a semiconductor package, a casting, a heat pipe, a radiator plate, a heat diffusing plate, and a thermally conductive adhesive layer to release such heat to the outside of electric components.

According to a second aspect of the present invention there is provided a method of manufacturing the thermally-conductive epoxy resin moulded article as disclosed in the first aspect, the method being characterised by:

adding a curing agent that reacts with the epoxy resin to cure the epoxy resin to the epoxy resin composition,

heating the epoxy resin composition containing the curing agent to subject the epoxy resin to curing reaction and applying a magnetic field to the epoxy resin composition during the curing reaction of the epoxy resin to orient the mesogenic group of the epoxy resin either in the direction of thickness of the sheet or in the direction parallel to a surface of the sheet wherein the degree of orientation a of the epoxy resin is equal to or larger than 0.5 and smaller than 1.0.

The degree of orientation can be calculated using the equation given above.

The curing reaction is typically performed at a temperature such that the liquid crystalline epoxy resin exhibits a state of mesomorphism.

An epoxy resin composition will now be described in detail. An epoxy resin contained in the epoxy resin composition has two or more epoxy groups in each molecule thereof and is cured by a curing agent such that a three dimensional structure is formed. Preferably, the epoxy resin composition mainly comprises an epoxy resin so as to make advantages of controlling the degree of orientation $\alpha$ to be sufficiently exhibited. Examples of the epoxy resin include a bisphenol-type epoxy resin, a novolak-type epoxy resin, a naphthalene-type epoxy resin, a triphenolalkane-type epoxy resin, and a biphenyl-type epoxy resin.

Among the above epoxy resins, a liquid crystalline epoxy resin having at least one mesogenic group in molecules thereof is preferable since the molecules can be easily oriented. A mesogenic group is a functional group that exhibits mesomorphism. Examples of such mesogenic groups include biphenyl, cyanobiphenyl, terphenyl, cyanoterphenyl, phenylbenzoate, azobenzene, azomethine, azoxybenzene, stilbene, phenylcyclohexyl, biphenylcyclohexyl, phenoxyphenyl, benzylidenaniline, benzylbenzoate, phenylpyrimidine, phenyldioxane, benzoylaniline, tolan, and derivatives of these. The liquid crystalline epoxy resin should have at least one mesogenic group in the molecule, and may include two or more mesogenic groups. Further, linking portions linking a plurality of mesogenic groups and tails of mesogenic groups are formed by flexible structure portions called flexible chains (spacers). As examples of the flexible structure portions, there may be mentioned an aliphatic hydrocarbon group, an aliphatic ether group, an aliphatic ester group, and a siloxane bond. In a certain temperature range, such a liquid crystalline epoxy resin changes into a liquid crystalline state where the mesogenic groups are regularly arranged. The above mesomorphism can be confirmed by a polarization inspection method utilizing an orthogonal polarizer. The liquid crystalline epoxy resin in the liquid crystalline state exhibits strong birefringence. Examples of the liquid crystalline state include nematic, smectic, cholesteric, and discotic liquid crystalline states.

Preferably, the epoxy resin composition is mixed with a curing agent for assisting curing of the epoxy resin contained therein. Examples of the curing agent include amine-based curing agents, acid anhydride-based curing agents, phenol-based curing agents, polymercaptan-based curing agents, polyaminoamide-based curing agents, isocyanate-based curing agents, and blockisocyanate-based curing agents. In mixing these curing agents with the epoxy resin composition, the amount of each curing agent to be mixed can be determined by taking into account the type of a curing agent to be mixed and the physical properties of a thermally-conductive epoxy resin molded article to be obtained as required. Preferably, with respect to 1 mole of the epoxy group, the amount of a curing agent to be mixed is 0.005 to 5, more preferably 0.01 to 3, most preferably 0.5 to 1.5 of the chemical equivalent. If the amount of the curing agent mixed with one mole of the epoxy group is smaller than 0.005 of chemical equivalent, the epoxy resin may not be cured quickly. On the other hand, if the amount of the mixed curing agent exceeds 5 of chemical equivalent, an extremely fast curing reaction takes place, which can make it difficult to control the orientation of the epoxy resin. It should be noted that the term "chemical equivalent" in the present specification represents, e.g. when an amine-based curing agent is used as the curing agent, the number of moles of active hydrogen of amines with respect to 1 mole of the epoxy group.

Examples of the amine-based curing agents include aliphatic amines, polyether polyamines, alicyclic amines, and aromatic amines. Examples of aliphatic amine include ethylenediamine, 1,3-diaminopropane, 1,4-diaminopropane, hexamethylenediamine, 2,5-dimethylhexamethylenediamine, trimethylhexamethylenediamine, diethylenetriamine, iminobispropylamine, bis(hexamethylene)triamine, triethylenetetramine, tetraethylenepentamine, pentaethylenehexamine, N-hydroxyethylethylenediamine, and tetra(hydroxyethyl)ethylenediamine, etc. Examples of polyetherpolyamine include triethyleneglycoldiamine, tetraethyleneglycoldiamine, diethyleneglycolbis(propylamine), polyoxypropylenediamine, and polyoxypropylenetriamine. Examples of alicyclic amine include isophoronediamine, menthanediamine, N-aminoethylpiperazine, bis(4-amino-3-methyldicyclohexyl)methane, bis(aminomethyl)cyclohexane, 3,9-bis(3-aminopropyl)2,4,8,10-tetraoxaspiro(5,5)undecane, and norbornenediamine. Examples of aromatic amine include tetrachloro-p-xylenediamine, m-xylenediamine, p-xylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulfone, 4,4'-diaminodiphenylsulfone, m-aminophenol, m-aminobenzylamine, benzyldimethylamine, 2-dimethylaminomethylphenol, triethanolamine, methylbenzylamine, $\alpha$-(m-aminophenyl)ethylamine, $\alpha$-(p-aminophenyl)ethylamine, diaminodiethyldimethyldiphenylmethane, and $\alpha,\alpha'$-bis(4-aminophenyl)-p-diisopropylbenzene.

Examples of acid anhydride curing agent include dodecenyl succinic anhydride, polyadipic acid anhydride, polyazelaic acid anhydride, polysebacic acid anhydride, poly(ethyloctadecanedioic acid)anhydride, poly(phenylhexadecanedioic acid)anhydride, methyltetrahydro phthalic anhydride, methylhexahydro phthalic anhydride, hexahydro phthalic anhydride, methylhymic anhydride, tetrahydro phthalic anhydride, trialkyltetrahydro phthalic anhydride, methylcyclohexenedicarboxylic anhydride, methylcyclohexenetetracarboxylic anhydride, phthalic anhydride, trimellitic anhydride, pyromellitic anhydride, benzophenonetetra carboxylic anhydride, ethylene grycolbistrimellitate, chlorendic anhydride, nadic anhydride, methylnadic anhydride, 5-(2,5-dioxotetrahydro-3-furanyl)-3-methyl-3-cyclohexane-1,2-dicarboxylic anhydride, 3,4-dicarboxy-1,2,3,4-tetrahydro-1-naphthalene succinic acid dianhydride, and 1-methyl-dicarboxy-1,2,3,4-tetrahydro-1-naphthalene succinic acid dianhydride.

Examples of phenol curing agent include bisphenol A, bisphenol F, phenol novalak, bisphenol A novalak, o-cresol novalak, m-cresol novalak, p-cresol novalak, xylenol novalak, poly-p-hydroxystyrene, resorcin, catechol, t-butylcatechol, t-butylhydrochinone, fluoroglycinol, pyrogallol, t-butylpyrogallol, allylated pyrogallol, polyallylated pyrogallol, 1,2,4-benzenetriol, 2,3,4-trihydroxybenzophenone, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,4-dihydroxynaphthalene, 2,5-dihydroxynaphthalene, 2,6-dihydroxynaohthalene, 2,7-dihydroxynaphthalene, 2,8-dihydroxynaphthalene, allyl compound or polyallyl compound of the above dihydronaphthalene, allylated bisphenol A, allylated bisphenol F, allylated phenol novalak, and allylated pyrogallol.

The above curing agents may be mixed alone or in combination. Further, as curing agents, there may be used a one-pack (latent) type curing agent that is premixed with an epoxy resin for reservation so as to cure the epoxy resin later e.g. by heating the mixture, or a two-pack type curing agent, which is mixed with an epoxy resin immediately before curing the epoxy resin. Examples of the one-pack (latent) type curing agent include dicyandiamide, guanidine compounds, nitrogen-containing compounds, such as adipic acid dihydrazide, sebacic acid dihydrazide, and isophthalic acid dihydrazide, amineimides, tertiary amine salts, imidazole salts, Lewis acids and salts thereof, and Bronsted acid salts.

It is also possible to cure the epoxy resin contained in the epoxy resin composition by carrying out cationic polymerization, using compounds, such as aluminum chloride ($AlCl_3$), tin tetrachloride ($SnCl_4$), titanium tetrachloride ($TiCl_4$), boron trifluoride ($BF_3$), phosphorus pentachloride ($PCl_5$), and antimony pentafluoride ($SbF_5$). Further, it is also possible to cure the epoxy resin contained in the epoxy resin composition by carrying out anionic polymerization using ammonium salts, such as tetrabutylammonium bromide, and dimethyldibenzylammonium chloride.

A suitable amount of thermally-conductive filler can be mixed into the epoxy resin composition in order to improve the thermal conductivity of the thermally-conductive epoxy resin molded article. Examples of thermally-conductive filler include metals, metal oxides, metal nitrides, metal carbides, metal hydroxides, metal-coated resins, carbon fiber, graphitized carbon fiber, natural graphite, synthetic graphite, spherical graphite particles, mesocarbon microbeads, whisker carbon, microcoiled carbon, nanocoiled carbon, carbon nanotube, and carbon nanohorn. Examples of metals include silver, copper, gold, platinum, and zircon; examples of metal oxides include aluminum oxide and magnesium oxide; examples of metal nitrides include boron nitride, aluminum nitride, and silicon nitride; examples of metal carbides include silicon carbide; and examples of metal hydroxides include aluminum hydroxide and magnesium hydroxide. These thermally-conductive fillers may be mixed alone or in combination. Further, so as to improve wettability between the epoxy resin and a thermally-conductive filler, to improve the interface of the thermally-conductive filler, and to enhance dispersibility thereof, the surface of the thermally-conductive filler may be treated with a coupling agent.

A large amount of thermally-conductive filler may be mixed with the epoxy resin composition in order to enhance the thermal conductivity of the thermally-conductive epoxy resin molded article that is obtained. More specifically, thermally-conductive filler may be mixed in an amount equal to or larger than 100 parts by weight, and smaller than 1000 parts by weight, with respect to 100 parts by weight of the epoxy resin. However, the amount of the thermally-conductive filler to be mixed with the epoxy resin composition is preferably smaller than 100 parts by weight, more preferably smaller than 80 parts by weight, further preferably smaller than 70 parts by weight. If the amount of the thermally-conductive filler is 100 parts by weight or more, with respect to 100 parts by weight of the epoxy resin, the thermally-conductive epoxy resin molded article is increased in density, which may make it difficult to reduce the weight of a material to which is applied the present invention. When a material to which is applied the present invention is required to be reduced in weight, it is preferable that the epoxy resin composition contains substantially no thermally-conductive filler. Here, the epoxy resin composition that contains substantially no thermally-conductive filler means preferably one that contains the filler in an amount equal to or smaller than 5 parts by weight, with respect to 100 parts by weight, more preferably one that contains the filler in an amount equal to or smaller than 1 part by weight with respect to 100 parts by weight of the epoxy resin, further preferably one that is formed of the epoxy resin alone.

Further, to the epoxy resin composition, there can be added small amounts of a pigment, a dye, a fluorescent brightening agent, a dispersant, a stabilizer, a UV absorbent, an energy quencher, an antistatic additive, an antioxidant, a fire retardant, a heat stabilizer, a slip additive, a plasticizer, a solvent, etc., if necessary.

Next, the thermally-conductive epoxy resin molded article will be described in detail.

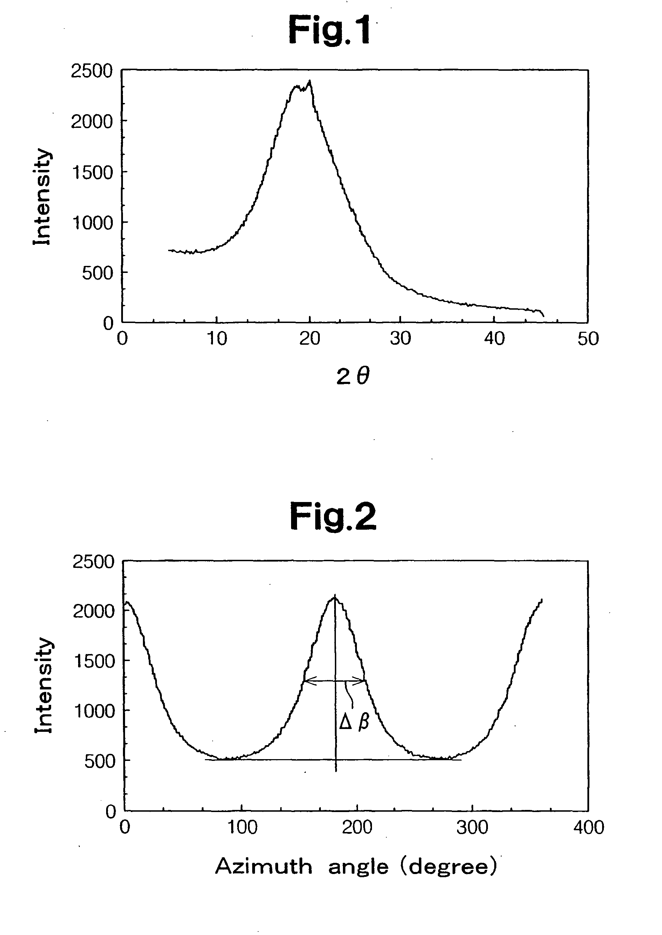

The degree of orientation $\alpha$ of the epoxy resin in the thermally-conductive epoxy resin molded article is determined by measuring the thermally-conductive epoxy resin molded article using wide angle x-ray diffraction based on the transmission method. Although known methods of measuring the degree of orientation $\alpha$ include a birefringence method, a two-color method for measuring orientations e.g. of segments in a specific absorption band, a fluorescence method, and a Raman scattering method, the x-ray diffraction measurement method is a most easy and convenient method for obtaining information of molecular orientations of the epoxy resin in the thermally-conductive epoxy resin molded article. To determine the degree of orientation $\alpha$, first, wide angle x-ray diffraction measurement is carried out on the molded article, whereby a diffraction pattern, as shown in Fig. 1, is obtained in an equatorial direction, i.e. a direction perpendicular to the direction of applying the magnetic field. In this diffraction pattern, it is considered that a diffraction peak at the position of $2\theta = 20$ represents distances between the molecular chains of the epoxy resin cured. The angle (peak scattering angle) of the diffraction peak is generally 20 degrees, although it may be larger or smaller than 20 degrees in a range of approximately 15 to 30 degrees, depending on the structure of epoxy resins and the formulation of the epoxy resin composition. By fixing the angle (peak scattering angle) of the diffraction peak to 20 degrees, and then measuring intensities of the thermally-conductive epoxy resin molded article, by changing an azimuth angle from 0 degree to 360 degrees, it is possible to obtain an intensity distribution, as shown in Fig. 2, against the azimuth angle direction. Then, based on the intensity distribution against the azimuth angle direction, the width (half-width $\Delta\beta$ [in degrees]) of the peak is obtained at a value equal to a half of the value of the peak height. The degree of orientation $\alpha$ is calculated by assigning the half-width $\Delta\beta$ into the above equation (1). In the case of the intensity distribution against the azimuth angle direction shown in Fig. 2, the half-width $\Delta\beta$ is 50 degrees, and the degree of orientation $\alpha$ is 0.72.

The degree of orientation $\alpha$ is equal to or larger than 0.5 and smaller than 1.0, preferably equal to or larger than 0.55 and smaller than 1.0, more preferably equal to or larger than 0.6 and smaller than 1.0, most preferably equal to or larger than 0.7 and smaller than 1.0. If the degree of orientation $\alpha$ is smaller than 0.5, the coefficient of thermal conductivity $\lambda$ is reduced, which makes it impossible to obtain an epoxy molded article with a sufficient thermal conductivity. On the other hand, one can understand that the half-width $\Delta\beta$ always becomes a positive value judging from the equation (1), and the degree of orientation $\alpha$ cannot exceed 1.0. If the degree of orientation $\alpha$ is equal to or larger than 0.5 and smaller than 1.0, the coefficient of thermal conductivity λ of the thermal conductivity is increased, thereby increasing thermal conductivity of the epoxy resin.

To obtain a thermally-conductive epoxy resin molded article from an epoxy resin composition, first, the epoxy resin composition is molded with a molding apparatus, and a magnetic field is applied to the epoxy resin composition with a magnetic field-generating device to orient an epoxy resin contained in the epoxy resin composition. Molecular chains of the epoxy resin are oriented in parallel with or perpendicularly to the magnetic lines of force of the magnetic field. Then, the epoxy resin is cured in the state of the epoxy resin being oriented, whereby it is possible to obtain a thermally-conductive epoxy resin molded article in which the degree of orientation α is controlled to fall into the range described above.

The magnetic field-generating device for generating the magnetic field includes a permanent magnet, an electromagnet, a super-conducting magnet, and a coil, for example. Among them, the super-conducting magnet is preferable since it is capable of generating a magnetic field having a practical magnetic flux density.

The magnetic flux density of the magnetic field applied to the epoxy resin composition is preferably 0.5 to 20 Tesla (T), more preferably 1 to 20 T, most preferably 2 to 10 T. If the magnetic flux density is smaller than 0.5 T, the molecular chains of the epoxy resin may not be sufficiently oriented. This can make it difficult to obtain a thermally-conductive epoxy resin molded article whose epoxy resin has an degree of orientation α equal to or larger than 0.5. On the other hand, it is practically difficult to produce a magnetic field having a magnetic flux density larger than 20 T. If the magnetic flux density is in the range of 2 to 10 T, a thermally-conductive epoxy resin molded article having a high coefficient of thermal conductivity λ can be obtained while a magnetic field having a magnetic flux density within the above range can be relatively easily generated.

As the molding apparatus for molding the epoxy resin, there can be used a transfer molding apparatus, a press molding apparatus, a cast molding apparatus, an injection molding apparatus, an extrusion molding apparatus, etc. Further, the thermally-conductive epoxy resin molded article can be formed into various shapes, such as sheet-like, film-like, block-like, grain-like, and fiber-like shapes.

Methods of curing the epoxy resin contained in the epoxy resin composition include self-polymerization of epoxy groups contained in the epoxy resin, and reaction between the above epoxy resin and the above curing agent. Such reactions include a thermal curing reaction, a light curing reaction, a radiation curing reaction, and a moisture curing reaction.The coefficient of thermal conductivity λ of the thermally-conductive epoxy resin molded article is significantly increased along the length of the molecular chains of the epoxy resin, when the chains are oriented in a fixed direction, and the degree of orientation α is controlled to fall into the range described above. The coefficient of thermal conductivity λ is preferably between 0.5 and 30 W/(m·K), more preferably between 0.6 and 20 W/(m·K), most preferably between 0.7 and 10 W/(m·K). When the coefficient of thermal conductivity λ is smaller than 0.5 W/(m·K), effective transfer of heat generated from the electronic parts to the outside may be difficult. On the other hand, it is difficult to obtain a thermally-conductive epoxy resin molded article having a coefficient of thermal conductivity λ of more than 30 W/(m·K), taking into consideration the physical properties of the epoxy resin.

The thermally-conductive epoxy resin molded article according to the present embodiment has preferably a density of 1.10 to less than 2.10 g/cm$^3$, more preferably 1.20 to less than 1.90 g/cm$^3$, most preferably 1.30 to less than 1.80 g/cm$^3$. When the density of the thermally-conductive epoxy resin molded article is 2.10 g/cm$^3$ or more, reduction in weight of an object to which the thermally-conductive epoxy resin molded article is applied, for example, an electronic appliance, may be difficult. On the other hand, it is difficult to obtain a thermally-conductive epoxy resin molded article having a density of less than 1.10, taking into consideration the physical properties of the epoxy resin.

When the thermally-conductive epoxy resin molded article according to the present embodiment is molded into a sheet form, the sheet has preferably a thickness of between 0.02 and 10 mm, more preferably between 0.1 and 7 mm, most preferably between 0.2 and 5 mm. When the thickness of the sheet is less than 0.02 mm, handling of the thermally-conductive epoxy resin molded article may be burdensome when the molded article is used in an application object, such as an electronic appliance. On the other hand, when the thickness of the sheet exceeds 10 mm, reduction in weight of, for example, an electronic appliance may be difficult, and the thermal conductivity may decrease.

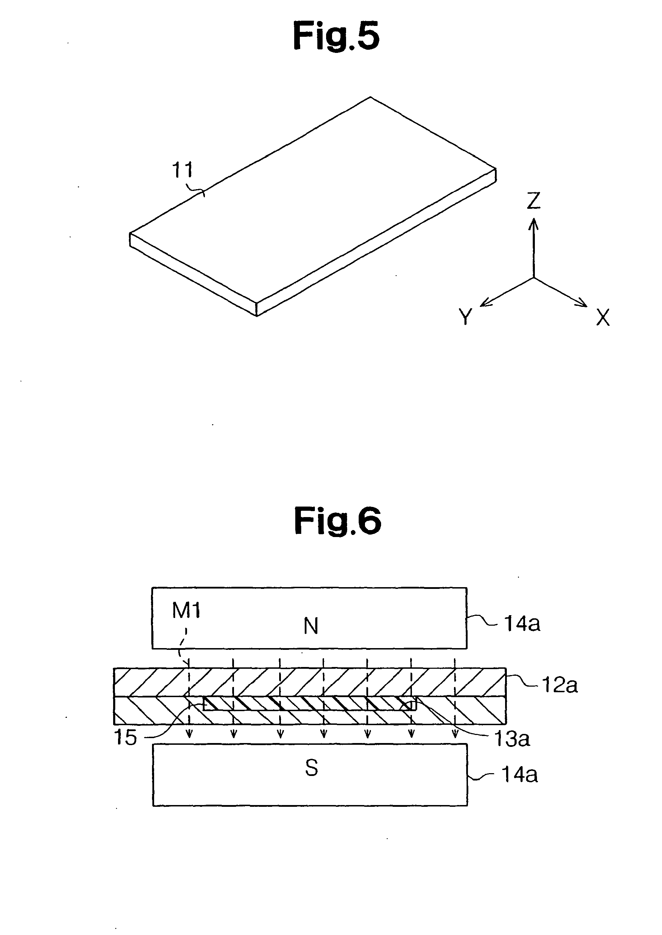

Next, a method for producing a thermally-conductive epoxy resin molded article from a epoxy resin according to one embodiment will be described in detail with reference to Figs. 5 to 7. Thermal conductive sheet 11 in a sheet form shown in Fig. 5, which is obtained as the thermally-conductive epoxy resin molded article of the present invention, can be applied to printed wiring board and electronic appliance as a radiating member, such as a radiating sheet.

Firstly, an explanation is made on the case where the molecular chains of the epoxy resin are aligned in the thickness direction of thermally conductive sheet 11 (the direction of Z axis in Fig. 5). As shown in Fig. 6, a cavity 13a having a shape corresponding to the sheet is formed in a mold 12a. A pair of permanent magnets 14a is disposed as a magnetic field generating apparatus above and under the mold 12a. The direction of magnetic lines of force M1 of the magnetic field generated by permanent magnets 14a is parallel to the thickness direction of the cavity 13a.

First, the cavity 13a is filled with a epoxy resin composition 15. The mold 12a has a heating apparatus (not shown) to keep the epoxy resin included in the epoxy resin composition 15 contained in the cavity 13a in a molten state.

If a liquid crystalline epoxy resin is included in the in the epoxy resin composition, the epoxy resin is kept in a liquid crystalline state. After filling the cavity 13a with the epoxy resin composition 15, a predetermined magnetic flux density of magnetic field is applied to the composition 15 by means of the permanent magnets 14a. The magnetic field may be applied to before the epoxy resin composition 15 is filled in the cavity 13a. In this instance, the direction of magnetic lines of force M1 is parallel to the thickness direction of the epoxy resin composition 15 in a sheet form, so that the molecular chains of the epoxy resin can be oriented in the thickness direction of the epoxy resin composition 15 in a sheet form. The thus-oriented epoxy resin composition 15 is solidified by causing a curing reaction, and then is removed from the mold 12a to obtain a thermal conductive sheet 11 in which the molecular chains in the epoxy resin composition 15 are oriented in the thickness direction.

The degree of orientation $\alpha$ of the thermal conductive sheet 11 is equal to or larger than 0.5 and smaller than 1.0. The thermal conductive sheet 11 has a high coefficient of thermal conductivity $\lambda$ in the thickness direction, and can be used in, for example, a circuit board material and a radiating sheet for use in semiconductor package, which require an excellent thermal conductivity in the thickness direction.

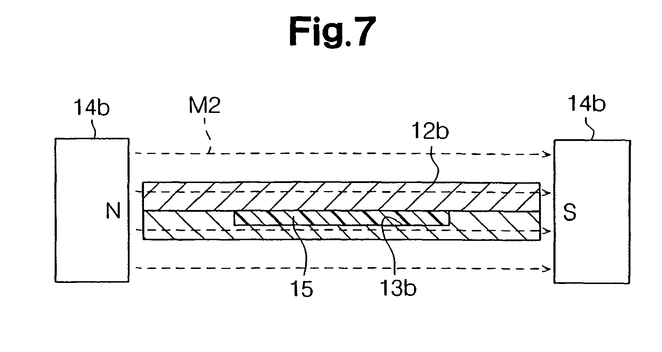

Next, a method for producing a thermally-conductive epoxy resin molded article is described according to another embodiment of the present invention. In this another embodiment, the direction of the molecular chains of the epoxy resin is aligned with the direction parallel to the surface of the thermal conductive sheet 11, i.e., the direction of X axis and/or the direction of Y axis in Fig. 5. As shown in Fig. 7, a pair of permanent magnets 14b are disposed on either side of a mold 12b so that magnetic lines of force M2 pass in the direction parallel to the bottom surface of a cavity 13b of the mold 12b having a form corresponding to the sheet to be formed. A magnetic field is applied by means of the permanent magnets 14b to a epoxy resin composition 15 in the cavity 13b having the epoxy resin. In this instance, the direction of magnetic lines of force M2 is parallel to the surface of epoxy resin composition 15 in a sheet form, so that the molecular chains of the epoxy resin can be oriented in the direction parallel to the surface of the epoxy resin composition 15. The thus-oriented epoxy resin composition 15 is solidified by curing reaction, and then removed from the mold 12b to obtain a thermal conductive sheet 11 in which the molecular chains of the epoxy resin are oriented in the direction parallel to the surface of the sheet.

The degree of orientation $\alpha$ of the thermal conductive sheet 11 in the direction parallel to the surface of the thermal conductive sheet 11 is preferably equal to or larger than 0.5 and smaller than 1.0. The thermal conductive sheet 11 has a high coefficient of thermal conductivity $\lambda$ in the direction parallel to the surface of the sheet, and can be used in, for example, a circuit board material and a radiating sheet for use in semiconductor package, which require excellent thermal conductivity in the direction parallel to the surface of the sheet.

Effects exhibited by the present embodiment will be described in the following:

- In the thermally-conductive epoxy resin molded article according to the present embodiment, the degree of orientation $\alpha$ of the cured epoxy resin is equal to or larger than 0.5 and smaller than 1.0. As a result, the molded article has a high coefficient of thermal conductivity $\lambda$ in the direction of orientation of the epoxy rein, and exhibits an excellent thermal conductivity. Further, even when the epoxy resin composition is mixed with a thermally-conductive filler to improve thermal conductivity of an obtained thermally-conductive epoxy resin molded article, the thermal conductivity is further enhanced by controlling the degree of orientation $\alpha$ of the epoxy resin in the range described above. Consequently, it is possible to impart excellent thermal conductivity to the molded article.

- It is preferable that in the thermally-conductive epoxy resin molded article according to the present embodiment, the epoxy resin is a liquid crystalline epoxy resin having at least one mesogenic group in respective molecules thereof. In this case, since the molecules of the liquid crystalline epoxy resin can be easily oriented, it is possible to easily obtain a thermally-conductive epoxy resin molded article having an excellent thermal conductivity.

- Preferably, the thermally-conductive epoxy resin molded article according to the present embodiment has a sheet-like shape, and the coefficient of thermal conductivity $\lambda$ of the molded article in the direction of thickness thereof is 0.5 to 30 W/(m·K). The thermally-conductive epoxy resin molded article thus formed can be applied to applications, such as circuit board materials and heat-dissipating sheets, which have a sheet-like shape and required to have high thermal conductivity in the direction of thickness thereof.

- In the method of manufacturing the thermally-conductive epoxy resin molded article according to the present embodiment, the epoxy resin is cured after an magnetic field is applied to the epoxy resin composition in a fixed direction. According to this manufacturing method, it is possible to cause the molded article to sufficiently exhibit the characteristics of epoxy resins, such as electrical insulation properties, mechanical properties, heat resistance, chemical resistance, adhesive properties, and low density, and easily obtain the thermally-conductive epoxy resin molded article having an excellent thermal conductivity.

It should be apparent to those skilled in the art that the present invention may be embodied in many other specific forms without departing from the spirit or scope of the invention. Particularly, it should be understood that the invention may be embodied in the following forms.

It should be noted that the following variations of the above-described embodiment are possible:

- The epoxy resin composition may be mixed with a conventional filler, such as glass fibers or the like, other than the thermally-conductive fillers.
- The epoxy resin composition may include only an epoxy resin having no mesomorphism, or alternatively a liquid crystalline epoxy resin alone. Further, the epoxy resin composition may contain both an epoxy resin and a liquid crystalline epoxy resin.
- The epoxy resin composition may be mixed with a curing agent having at least one mesogenic group and exhibiting mesomorphism.
- A pair of permanent magnets 14a/14b is disposed so that a mold 12a/12b is placed between the mold, but one of the paired permanent magnets may be omitted.
- A pair of south pole magnets or a pair of north pole magnets may be disposed so that the pair oppose to each other.
- The magnetic lines of force M1/M2 may be straight. However, they may be curved or in other shapes. In addition, either the magnetic lines of force M1/M2 or the cavity 12a/12b may be rotated.

Next, the above-described embodiment will be described in more detail based on examples and comparative examples.

(Example 1)

Terephthalylidene-bis-(4-amino-3-methylphenol) diglycidylether (hereinafter referred to as the "liquid crystalline epoxy resin A"), which is a liquid crystalline epoxy resin, as an epoxy resin, and 4,4'-diamino-1,2-diphenylethane as a curing agent were mixed with each other at a molar ratio of 1 : 0.5 to prepare an epoxy resin composition. After the epoxy resin composition was molten in a cavity of a molding die heated to 170°C, a magnetic field having a magnetic flux density of 5 Tesla was applied to the epoxy resin composition at 170°C for 10 minutes for curing, whereby a thermally-conductive sheet having a thickness of 2 mm was produced as a thermally-conductive epoxy resin molded article. It should be noted that the magnetic lines of force were applied in the direction of thickness of the sheet-type epoxy resin composition.

(Example 2)

The same epoxy resin composition as used in Example 1 was used, and a thermally-conductive sheet was prepared by following the same procedure as in Example 1 except that the magnetic flux density was changed to a value shown in Table 1.

(Example 3)

1,5-bis-[4-[2-aza-2-(methyl-4-hydroxyphenyl)-vinyl] phenoxy] pentanediglycidylether (hereinafter referred to as the "liquid crystalline epoxy resin B"), which is a liquid crystalline epoxy resin, as an epoxy resin, and 4,4'-diamino-1,2-diphenylethane as a curing agent were mixed with each other at a molar ratio of 1 : 0.5, whereby an epoxy resin composition was prepared. After the epoxy resin composition was molten in a cavity of a molding die heated to 105°C, a magnetic field having a magnetic flux density of 10 Tesla was applied to the epoxy resin composition at 150°C for two hours for curing, whereby a thermally-conductive sheet having a thickness of 2 mm was produced as a thermally-conductive epoxy resin molded article. It should be noted that the magnetic lines of force were applied in the direction of thickness of the sheet-type epoxy resin composition.

(Example 4)

Dihydroxy-$\alpha$-methylstilbenediglycidylether (hereinafter referred to as the "liquid crystalline epoxy resin C"), which is a liquid crystalline epoxy resin, as an epoxy resin, and 4,4'-diamino-1,2-diphenylethane as a curing agent were mixed with each other at a molar ratio of 1 : 0.5, whereby an epoxy resin composition was prepared. After the epoxy resin composition was molten in a cavity of a molding die heated to 150°C, a magnetic field having a magnetic flux density of 10 Tesla was applied to the epoxy resin composition at 150°C for one hour for curing, whereby a thermally-conductive sheet having a thickness of 2 mm was produced as a thermally-conductive epoxy resin molded article. It should be noted that the magnetic lines of force were applied in the direction of thickness of the sheet-type epoxy resin composition.

(Example 5)

1,4-bis-[4-(4-hydroxybenzoate) phenoxy] butanediglycidylether (hereinafter referred to as the "liquid crystalline epoxy resin D"), which is a liquid crystalline epoxy resin, as an epoxy resin, and 4,4'-diamino-1,2-diphenylethane as a curing agent were mixed with each other at a molar ratio of 1 : 0.5, whereby an epoxy resin composition was prepared. After the epoxy resin composition was molten in a cavity of a molding die heated to 150°C, a magnetic field having a magnetic flux density of 10 Tesla was applied to the epoxy resin composition at 150°C for three hours for curing, whereby a thermally-conductive sheet having a thickness of 2 mm was produced as a thermally-conductive epoxy resin molded article. It should be noted that the magnetic lines of force were applied in the direction of thickness of the sheet-type epoxy resin composition.

(Comparative Example 1)

After the same epoxy resin composition as used in Example 1 was molten in a cavity of a molding die heated to 170°C, the epoxy resin composition was cured at 170°C for 10 minutes without application of a magnetic field, whereby a sheet-type molded article was produced having a thickness of 2 mm.

(Comparative Example 2)

After the same epoxy resin composition as used in Example 3 was molten in a cavity of a molding die heated to 150°C, the epoxy resin composition was cured at 105°C for two hours without application of a magnetic field, whereby a sheet-type molded article was produced having a thickness of 2 mm.

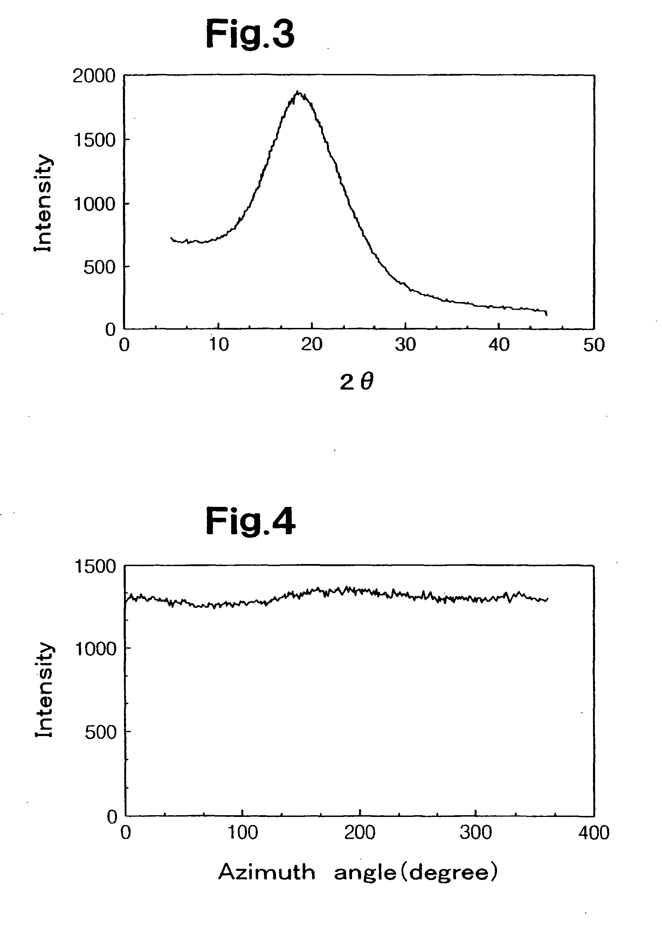

The degree of orientations $\alpha$ of the epoxy resin compositions used in Examples 1 to 5, and Comparative Examples 1 and 2 were calculated using an x-ray diffraction apparatus available from MAC Science Co., Ltd. (Yokohama, Japan). A diffraction pattern of the epoxy resin composition of Example 2, in an equatorial direction, obtained by an x-ray diffraction measurement is shown in Fig. 1, and an intensity distribution of the epoxy resin composition of Example 2, in an azimuth angle direction, at a diffraction peak angle of $2\theta$ = 20 degrees is shown in Fig. 2. Further, a diffraction pattern of the epoxy resin composition of Comparative Example 1, in an equatorial direction, obtained by an x-ray diffraction measurement is shown in Fig. 3, and an intensity distribution of the epoxy resin composition of Comparative Example 1, in an azimuth angle direction, at a diffraction peak angle of $2\theta$ = 20 degrees is shown in Fig. 4.

The coefficients of thermal conductivity $\lambda$ of the epoxy resin compositions used in Examples 1 to 5, and Comparative Examples 1 and 2, in the directions of thickness thereof were measured by laser flash method. In this method, a laser beam is irradiated onto a top surface of samples for measuring a temperature of a bottom surface of the samples over time, whereby a specific heat at constant pressure (Cp), and thermal diffusivity ($\alpha$) are calculated. The coefficient of thermal conductivity $\lambda$ is calculated by the following equation:

$$\lambda = \alpha \times Cp \times \rho \quad (\rho: \text{ density of samples})$$

The degree of orientations $\alpha$ and coefficients of thermal conductivity $\lambda$ of the epoxy resin compositions of Example 1 to Example 5, and Comparative Example 1 and Comparative Example 2 are shown in Table 1.

Table 1

| | Examples | | | | | Comparative Examples | |
|---|---|---|---|---|---|---|---|
| | 1 | 2 | 3 | 4 | 5 | 1 | 2 |
| Liquid crystalline epoxy resin | A | A | B | C | D | A | B |
| Magnetic flux density (T) | 5 | 10 | 10 | 10 | 10 | 0 | 0 |
| Degree of orientation $\alpha$ | 0.70 | 0.72 | 0.59 | 0.60 | 0.69 | 0 | 0 |
| Coefficient of thermal conductivity $\lambda$ | 0.80 | 0.89 | 0.53 | 0.58 | 0.72 | 0.43 | 0.33 |

From the results of measurements shown in Table 1, it is clear that in Examples 1 to 5, it is possible to obtain thermally-conductive sheets of epoxy resin compositions having degrees of orientations $\alpha$ of not smaller than 0.5, and each of them has an excellent thermal conductivity with a coefficient of thermal conductivity $\lambda$ in the direction of thickness of the epoxy resin composition being equal to or larger than 0.5 W/(m·K). As described above, in Examples 1 to 5, it was possible to obtain thermally-conductive sheets suitable for use in the latest high-performance electronic components.

On the other hand, in Comparative Examples 1 and 2, the epoxy resin compositions thereof have degrees of orientations $\alpha$ smaller than 0.5, and coefficients of thermal conductivity $\lambda$ smaller than 0.5 W/(m·K), which shows that the epoxy resin compositions are low in thermal conductivity.

**Claims**

1. A thermally-conductive epoxy resin moulded article obtained by curing an epoxy resin composition containing an epoxy resin, **characterised in that** the degree of orientation $\alpha$ of the epoxy resin is equal to or larger than 0.5 and smaller than 1.0, the degree of orientation $\alpha$ being determined by the following equation:

$$\text{degree of orientation } \alpha = (180 - \Delta\beta)/180$$

wherein $\Delta\beta$ represents a half-width of a peak in an intensity distribution measured by fixing to a peak scattering angle in an x-ray diffraction measurement and then changing an azimuth angle from 0 degree to 360 degrees the thermally-conductive epoxy resin moulded article is a sheet,
the epoxy resin is a liquid crystalline epoxy resin having at least one mesogenic group in respective molecules thereof, the mesogenic group of the epoxy resin is oriented in a direction of thickness of the sheet or in a direction parallel to a surface of the sheet,
and a coefficient of thermal conductivity $\lambda$ in the direction of thickness or direction parallel to the surface thereof is 0.5 to 30 W/(m·K).

2. A method of manufacturing the thermally-conductive epoxy resin moulded article according to Claim 1, the method being
**characterised by**:

adding a curing agent that reacts with the epoxy resin to cure the epoxy resin to the epoxy resin composition, heating the epoxy resin composition containing the curing agent to subject the epoxy resin to curing reaction, and applying a magnetic field to the epoxy resin composition during the curing reaction of the epoxy resin to orient the mesogenic group of the epoxy resin either in the direction of thickness of the sheet or in the direction parallel to a surface of the sheet wherein the degree of orientation $\alpha$ of the epoxy resin is equal to or larger than 0.5 and smaller than 1.0.

3. A method as claimed in Claim 2 wherein the curing reaction is performed at a temperature such that the liquid crystalline epoxy resin exhibits a state of mesomorphism.

**Patentansprüche**

1. Wärmeleitfähiger, aus Epoxidharz geformter Gegenstand, der durch Härten einer Epoxidharz-Zusammensetzung erhalten wird, enthaltend ein Epoxidharz, **dadurch gekennzeichnet, dass** der Orientierungsgrad $\alpha$ des Epoxidharzes gleich oder größer als 0,5 und kleiner als 1,0 ist, wobei der Orientierungsgrad $\alpha$ durch die folgende Gleichung bestimmt wird:

$$\text{Orientierungsgrad } \alpha = (180 - \Delta\beta)/180$$

worin $\Delta\beta$ eine halbe Breite eines Peaks in einer Intensitätsverteilung darstellt, die durch Fixieren auf einen Peak-Streuungswinkel in einer Röntgenbeugungsmessung und dann Änderung eines Azimutwinkels von 0 ° bis 360 ° gemessen wird,
der wärmeleitfähige, aus Epoxidharz geformte Gegenstand eine Folie darstellt,
das Epoxidharz ein flüssigkristallines Epoxidharz mit mindestens einer mesogenen Gruppe in entsprechenden Molekülen davon darstellt,
die mesogene Gruppe des Epoxidharzes in einer Richtung der Dicke der Folie oder in einer Richtung parallel zu einer Oberfläche der Folie orientiert ist,
und ein Koeffizient der Wärmeleitfähigkeit $\lambda$ in der Richtung der Dicke oder der Richtung parallel zur Oberfläche davon 0,5 bis 30 W/(m · K) beträgt.

2. Verfahren zur Herstellung des wärmeleitfähigen, aus Epoxidharz geformten Gegenstandes nach Anspruch 1, wobei das Verfahren **gekennzeichnet ist durch**:

   Zufügen eines Härtungsmittels, das mit dem Epoxidharz zum Härten des Epoxidharzes zur Epoxidharz-Zusammensetzung reagiert,
   Erhitzen der Epoxidharz-Zusammensetzung, enthaltend das Härtungsmittel, um das Epoxidharz der Härtungsreaktion zu unterziehen und
   Aufbringen eines Magnetfeldes auf die Epoxidharz-Zusammensetzung während der Härtungsreaktion des Epoxidharzes zur Orientierung der mesogenen Gruppe des Epoxidharzes entweder in der Richtung der Dicke der Folie oder in der Richtung parallel zu einer Oberfläche der Folie, worin der Orientierungsgrad $\alpha$ des Epoxidharzes gleich oder größer als 0,5 und kleiner als 1,0 ist.

3. Verfahren nach Anspruch 2, worin die Härtungsreaktion bei einer Temperatur dergestalt durchgeführt wird, dass das flüssigkristalline Epoxidharz einen Zustand des Mesomorphismus aufweist.


**Revendications**

1. Article moulé à partir d'une résine époxy thermo-conductrice obtenue par cuisson d'une composition à base d'une résine époxy contenant une résine époxy **caractérisée en ce que** le degré d'orientation $\alpha$ de la résine époxy est égal ou supérieur à 0,5 et inférieur à 1,0, le degré d'orientation $\alpha$ étant déterminée au moyen de l'équation suivante :

$$\text{degré d'orientation } \alpha = (180 - \Delta\beta)/180$$

   où $\Delta\beta$ représente la demi-largeur d'un pic de la distribution de l'intensité mesurée par diffraction des rayons X à un angle de diffusion maximal fixe puis en faisant varier l'angle azimutal de 0 degré à 360 degrés,
   l'article moulé à partir d'une résine époxy thermo-conductrice est une feuille,
   la résine époxy est une résine époxy cristalline liquide qui contient au moins un groupement mésogène dans des molécules respectives de celle-ci,
   le groupement mésogène de la résine époxy est orienté dans une direction de l'épaisseur de la feuille ou dans une direction parallèle à la surface de la feuille,
   et le coefficient de conductivité thermique $\lambda$ dans la direction de l'épaisseur ou dans la direction parallèle à la surface est compris entre 0,5 et 30 W/(m·K).

2. Méthode de fabrication de l'article moulé à partir d'une résine époxy thermo-conductrice selon la revendication 1, la méthode étant **caractérisée par** :

   l'addition d'un agent de cuisson qui réagit avec la résine époxy pour produire la cuisson de la résine époxy à la composition à base de résine époxy,
   l'exposition à la chaleur de la composition à base de résine époxy contenant l'agent de cuisson pour soumettre la résine époxy à une réaction de cuisson et
   l'application d'un champ magnétique à la composition à base de résine époxy durant la réaction de cuisson de la résine époxy pour orienter le groupement mésogène de la résine époxy soit dans la direction de l'épaisseur de la feuille, soit dans la direction parallèle à la surface de la feuille de façon à ce que le degré d'orientation $\alpha$ de la résine époxy soit égal ou supérieur à 0,5 et inférieur à 1,0.

3. Méthode selon la revendication 2, où la réaction de cuisson est réalisée à une température telle que la résine époxy cristalline liquide présente un état de mésomorphie.

## Fig.1

## Fig.2

# Fig.3

# Fig.4

# Fig.5

# Fig.6

# Fig.7